# FASCICULE DE BREVET EUROPEEN

(11) **EP 1 749 310 B1**
(45) Date de publication et mention de la délivrance du brevet: **12.05.2010**
(21) Numéro de dépôt: 05766585.3
(22) Date de dépôt: 26.05.2005
(51) Int. Cl.: H01L 21/20, H01L 29/786

(54) **SUBSTRAT POUR APPLICATION ELECTRONIQUE, COMPRENANT UN SUPPORT FLEXIBLE ET SON PROCEDE DE FABRICATION**
SUBSTRATE ZUR ELEKTRONISCHEN ANWENDUNG MIT EINEM FLEXIBLEN TRÄGER UND HERSTELLUNGSVERFAHREN DAFÜR
SUBSTRATE FOR ELECTRONIC APPLICATION COMPRISING A FLEXIBLE SUPPORT AND METHOD FOR PRODUCTION THEREOF

(30) Priorité: 27.05.2004 FR 0451045
(43) Date de publication de la demande: 07.02.2007
(73) Titulaire: Commissariat à l'énergie atomique et aux énergies alternatives, 75015 Paris (FR)
(72) Inventeur: LE BLEVENNEC, Gilles, F-38190 BERNIN (FR); PRENE, Philippe, F-37200 TOURS (FR)
(74) Mandataire: Poulin, Gérard
(86) Numéro de dépôt international: PCT/FR2005/050373
(87) Numéro de publication internationale: WO 2005/119743

(56) Documents cités:
- EP-A- 0 797 258
- EP-A- 0 851 513
- US-A1- 2003 017 712
- PATENT ABSTRACTS OF JAPAN vol. 2003, no. 12, 5 décembre 2003 (2003-12-05) -& JP 2004 074609 A (TOPPAN PRINTING CO LTD), 11 mars 2004 (2004-03-11)
- ASAKUMA N ET AL: "LOW-TEMPERATURE SYNTHESIS OF ITO THIN FILMS USING AN ULTRAVIOLET LASER FOR CONDUCTIVE COATING ON ORGANIC POLYMER SUBSTRATES" JOURNAL OF SOL-GEL SCIENCE AND TECHNOLOGY, KLUWER ACADEMIC PUBLISHERS, DORDRECHT, NL, vol. 27, no. 1, mai 2003 (2003-05), pages 91-95, XP008038677 ISSN: 0928-0707

## Description

### DOMAINE TECHNIQUE

L'invention concerne un substrat pour application électronique, comprenant un support flexible. Ce substrat peut être destiné à une utilisation pour l'électronique organique ou inorganique. L'invention concerne également son procédé de fabrication.

Parmi les applications possible de ce substrat, on peut citer les domaines suivants :
- écrans plats de visualisation, télévisions, ordinateurs ;
- écrans souples pour téléphones ou objets électroniques nomades, jeux vidéo ;
- étiquettes intelligentes (traceur de chaîne de froid, marquage, identification) ;
- systèmes d'identification par radiofréquence (RFID), lecture à distance, facturation automatique ;
- cartes à puce, cartes à puce intelligentes ou « smart card », circuits sur support fin et flexible ;
- capteurs, lecteurs d'empreintes digitales ;
- biocapteurs, systèmes électroniques associés aux puces à ADN (ou « biochip ») ;
- supports pour cellules photovoltaïques ;
- supports pour électronique de bas coût pour des applications grande surface ;
- papier ou livre électronique (ou « e-book ».

### ÉTAT DE LA TECHNIQUE ANTÉRIEURE

Réaliser de l'électronique sur des grandes surfaces est une nécessité notamment pour les fabricants d'écrans de visualisation. En effet, il est nécessaire pour faire fonctionner un écran à cristaux liquides (LCD) ou à diodes organiques électroluminescentes (OLED) d'avoir un circuit électronique en face arrière pour commander les pixels (ou éléments d'image) de l'écran. Aujourd'hui, cette électronique est réalisée à partir d'une technologie sur verre où l'on vient déposer du silicium amorphe à basse température. Ce silicium amorphe de basse performance sert pour la fabrication de transistors sur la face arrière de l'écran. Cette activité est aujourd'hui particulièrement développée et elle évolue rapidement vers une technologie dite du silicium polycristallin. Cette technologie consiste à cristalliser le silicium amorphe pour lui donner de meilleures propriétés électroniques et autoriser la réalisation de circuits de plus en plus performants pour la commande des écrans.

Faire évoluer cette technologie vers des substrats flexibles en remplacement du verre est un objectif pour beaucoup de fabricants. L'intérêt pour cela est de trouver un substrat peu coûteux, non fragile éventuellement « conformable » c'est-à-dire qui puisse s'adapter sur des surfaces non planes, voire flexibles.

Beaucoup de travaux récents portent sur des substrats plastiques.

L'article « A conformable Electronic Ink Display using a Foil-Based a-Si TFT Array » de Y. CHEN et al., publié dans SID 01 Digest, pages 157-159, divulgue la réalisation de transistors et de capacités en couche mince sur une couche de silicium amorphe déposée sur une feuille d'acier inoxydable. Cet article mentionne le dépôt d'une couche de passivation sur la feuille métallique préalablement polie. Cet article ne divulgue ni la composition de cette couche de passivation, ni la technique de dépôt utilisée.

D'autres articles divulguent différentes réalisations de transistors sur des feuilles métalliques. On peut citer :
- « Amorphous Silicon Thin Film Transistors on Steel Foil Substrates » de S.D. THEISS et S. WAGNER, IEEE Electron Device Letter, Vol. 17, 1999, pages 578-580;
- « Flexible, Lightweight Steel Foil Substrates for Amorphous Silicon Thin Film Transistors » de S.D. THEISS et S. WAGNER, SID AM-LCD 96 Tech. Dig., 1996, pages 365-368;
- « Complementary Metal-Oxide-Semiconductor Thin-Film Transistor Circuits from a High-Temperature Polycrystalline Silicon Process on Steel Foil Substrates » de Ming WU et al., Vol. 49, N°11, Novembre 2002.

EP-A-0797 258 (Sony Corporation) 24 September 1997 décrit une méthode pour masquer une couche mince semiconductrice, particulièrement adaptée à la réalisation de couche mince crystalline.

Ces articles divulguent la faisabilité de réalisation de transistors sur du silicium amorphe ou polycristallin à partir d'un substrat métallique flexible ou rigide. Cependant, le dépôt des couches de passivation entre la couche de silicium et la feuille métallique est toujours réalisé par une technique sous vide, principalement le PECVD (pour « Plasma Enhanced Chemical Vapor Deposition »). Le PECVD nécessite une mise sous vide des échantillons et un chauffage à 300°C pour obtenir une couche de passivation présentant les propriétés requises. Par ailleurs, les couches obtenues sont denses, ce qui les rend cassantes.

### EXPOSÉ DE L'INVENTION

Il est proposé, selon la présente invention, un procédé de fabrication d'un substrat pour application électronique comprenant un support flexible et une couche de passivation déposée par une méthode froide.

L'invention a donc pour objet un substrat pour application électronique comprenant un support flexible recouvert successivement d'une couche électriquement isolante et d'une couche de silicium polycristallin ou amorphe, **caractérisé en ce que** la couche électriquement isolante est une couche d'oxyde poreuse.

La couche d'oxyde poreuse assure une isolation électrique par rapport au support flexible. Elle sert de couche d'amortissement pour atténuer les tensions mécaniques qui pourraient être communiquées à la couche de silicium. Elle permet aussi d'obtenir une flexibilité mécanique de l'empilement réalisé. La structure poreuse permet, par sa capacité à se déformer, de tolérer les flexions ou extensions du support. Elle sert également de couche d'accrochage pour le silicium.

Avantageusement, le substrat peut comprendre en outre une couche de nivellement interposée entre la couche d'oxyde poreuse et la couche de silicium polycristallin ou amorphe. Cette couche de nivellement peut être une couche d'oxyde dense. L'oxyde dense (par exemple de la silice) sert également de barrière chimique pour d'éventuels polluants qui pourraient venir d'une partie métallique du support en traversant la couche d'oxyde poreuse.

Le support peut être choisi parmi le groupe constitué par une feuille de plastique, une feuille de papier, une feuille métallique souple et un ruban métallique souple. Il peut être en acier inoxydable. A titre d'exemple avantageux, la feuille métallique ou le ruban métallique sont en un matériau dont le coefficient de dilatation thermique est voisin de celui du silicium.

Si le support est une feuille de plastique ou de papier, ce support peut inclure au moins une piste métallique.

L'oxyde de la couche métallique poreuse peut être choisi parmi les oxydes de métaux ou de métalloïdes SiO₂, TiO₂, Ta₂O₅, Al₂O₃, ZrO₂, HfO₂ et MgO.

L'invention a aussi pour objet un procédé de fabrication d'un substrat pour application électronique, comprenant les étapes suivantes :
- fourniture d'un support flexible,
- dépôt, sur le support, d'une couche d'oxyde poreuse par une technique sol-gel,
- dépôt, sur la couche d'oxyde poreuse, d'une couche de silicium amorphe.

Le procédé peut comprendre en outre une étape de transformation du silicium amorphe en silicium polycristallin.

Le dépôt de la couche d'oxyde poreuse par une technique sol-gel est particulièrement intéressant pour les applications envisagées par l'invention. C'est un dépôt par voie humide qui peut se faire sur des objets par trempage ou par enduction laminaire. Il n'y a pas besoin de faire le vide et cette technique peut être mise en oeuvre en ligne ou au déroulé.

La couche de silicium amorphe peut être déposée par une technique PECVD ou une technique de pulvérisation. Il est à noter qu'il serait avantageux de déposer la couche de silicium amorphe ou polycristallin par une technique sol-gel.

La transformation du silicium amorphe en silicium polycristallin peut être réalisée au moyen d'un faisceau laser UV ou par SPC (pour « Solid Phase Crystallization ») dans un four adapté.

Le procédé peut comprendre, entre l'étape de dépôt de la couche d'oxyde poreuse et l'étape de dépôt de la couche de silicium amorphe, une étape de dépôt d'une couche de nivellement sur la couche d'oxyde poreuse. Avantageusement, la couche de nivellement est une couche d'oxyde dense.

### BRÈVE DESCRIPTION DES DESSINS

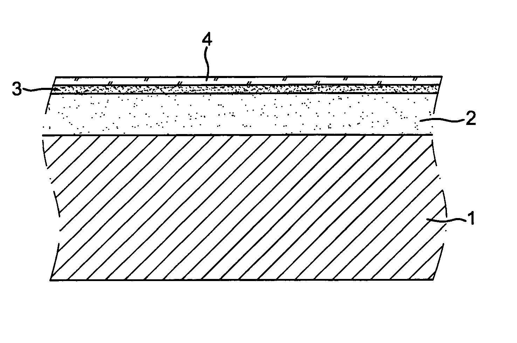

L'invention sera mieux comprise et d'autres avantages et particularités apparaîtront à la lecture de la description qui va suivre, donnée à titre d'exemple non limitatif, accompagnée du dessin annexé qui est vue en coupe transversale d'un substrat pour application électronique selon l'invention.

### EXPOSÉ DÉTAILLÉ DE MODES DE RÉALISATION PARTICULIERS

Le dessin annexé est une vue en coupe transversale d'un substrat pour application électronique selon la présente invention.

Le substrat comprend un support flexible 1, c'est-à-dire un support apte à accepter au moins une courbure, par exemple une feuille métallique souple. Le substrat est choisi de sorte que ses propriétés de flexion soient compatibles avec l'application envisagée. Le matériau de la feuille métallique peut également être choisi de façon à présenter un coefficient de dilatation thermique faible ou compatible avec le coefficient de dilatation thermique du silicium soit 4,2.10⁻⁶ K⁻¹. Ce matériau métallique peut être de l'invar (marque déposée) de formule Fe₆₄Ni₃₆ qui présente un coefficient de dilatation thermique de 1,7 à 2.10⁻⁶ K⁻¹. D'autres alliages peuvent également convenir. L'acier inoxydable peut avantageusement être utilisé car il présente de bonnes propriétés de flexion et est compatible avec de hautes températures.

Le support est de préférence métallique. Cependant, il peut également être réalisé en matériau isolant, par exemple en plastique (tel qu'un polyimide) ou en papier, et comprendre ou non des pistes conductrices métalliques. Il peut aussi être en matériau semiconducteur et comprendre ou non des pistes conductrices métalliques. Ce support doit être relativement dense et compatible avec les étapes technologiques ultérieures. Il doit en particulier ne pas être trop rugueux en surface. Il peut, au besoin, être recouvert d'une couche anti-oxydante (par exemple une couche de SiO₂ dense) pour le protéger lors des étapes technologiques ultérieures.

Une couche d'un oxyde poreux comme de la silice poreuse 2 est déposée sur le support 1 par une technique sol-gel. C'est une technique qui se pratique en solution par voie humide et qui synthétise des matériaux de qualité électronique.

Pour le procédé sol-gel, par précurseurs d'oxyde, on entend selon l'invention des composés alcoxydes de formule M (OR)ₙ avec M représentant un élément métallique ou un élément métalloïde tel que défini ci-dessus, R représentant un groupe alkyle comprenant de 1 à 6 atomes de carbone, n représentant la valence de l'élément métallique ou de l'élément métalloïde, l'alcoxyde pouvant être remplacé par un précurseur minéral (sel métallique) ou tout autre précurseur moléculaire de métal ou d'élément métalloïde pouvant s'hydrolyser.

Selon l'invention, la solution déposée sur le support est obtenue selon la technique de polymérisation par voie «sol-gel» qui traduit le terme «solution-gélatine».

Selon cette technique sol-gel, la solution susmentionnée est synthétisée, généralement en mélangeant un ou plusieurs précurseurs tels que définis précédemment dans un milieu comprenant au moins un solvant organique ou aqueuse suivi d'une hydrolyse totale ou partielle desdits précurseurs et d'une condensation desdits précurseurs ainsi hydrolysés.

Le ou les solvants organiques dans lesquels sont mélangés les précurseurs d'oxydes semi-conducteurs sont généralement des solvants alcooliques, en particulier des alcools aliphatiques, tels que l'éthanol ou l'isopropanol.

L'hydrolyse des précurseurs est obtenue généralement par ajout au mélange d'une solution aqueuse (acide, basique ou neutre). Une fois hydrolysés, les précurseurs présentent des groupes réactifs, tels que -OH, aptes à se condenser au cours d'une étape de condensation à l'issue de laquelle la solution comprend des espèces chimiques sous forme d'oligomères, de polymères ou de colloïdes.

L'homme du métier choisira, selon la nature des précurseurs, les conditions d'hydrolyse (pH, quantité d'eau additionnée...) de ces précurseurs pour obtenir dans la solution des espèces chimiques sous forme d'oligomères, de polymères ou de colloïdes.

Cette technique peut comprendre une étape de trempage (« dip coating » en anglais) et/ou d'enduction centrifuge (ou « spin coating ») et/ou de pulvérisation (ou « spray coating ») et/ou d'épandage (ou « soak coating ») et/ou d'enduction au rouleau (ou « roll to roll process ») et/ou d'enduction au pinceau (ou « paint coating ») et/ou de sérigraphie (ou « screen printing »), comme le connaît l'homme de l'art.

La couche d'oxyde poreux peut procurer une isolation électrique par rapport au support si celui-ci est métallique. Une couche de silice poreuse de typiquement 1 à 5 µm d'épaisseur permet de s'affranchir des phénomènes capacitifs parasites.

On entend par couche poreuse une couche apte à permettre le passage d'un gaz et/ou une couche contenant des bulles (de vide, de gaz ou de liquide). Elle permet de conférer une certaine souplesse à la couche. L'oxyde peut être un oxyde de métaux ou de métalloïdes comme par exemple MgO, SiO₂, ZrO₂, Al₂O₃, TiO₂, Ta₂O₅ et HfO₂.

Par oxyde de métaux, on entend, selon l'invention, un oxyde comprenant dans son réseau cristallin ou amorphe un ou plusieurs éléments métalliques. Ces éléments métalliques peuvent être des métaux de transition ou des métaux lanthanides, tels que ceux définis ci-après. L'élément métallique de transition peut être choisi parmi Ti, V, Cr, Mn, Fe, Co, Ni, Cu, Zn, Y, Zr, Nb, Mo, Ru, Rh, Pd, Ag, Cd, Hf, Ta, W, Re, Os, Ir, Pt. L'élément lanthanide peut être choisi parmi La, Ce, Pr, Nd, Sm, Eu, Gd, Tb, Dy, Er et Yb. Les éléments métalliques peuvent être également des métaux dits post-transitionnels, tels que ceux appartenant à la colonne IIIA (Al, Ga, In, TI) et la colonne IVA (Ge, Sn, Pb) de la classification périodique des éléments.

Par oxyde de métalloïdes, on entend, au sens de l'invention, un oxyde comprenant dans son réseau cristallin un ou plusieurs éléments métalloïdes, lesdits éléments métalloïdes étant choisis parmi Si, Se, Te.

Tous ces matériaux sont compatibles avec un dépôt sol/gel. Ils sont réfractaires. En jouant sur le caractère réfractaire ainsi que sur l'épaisseur de cette couche, on peut rendre le support sous-jacent compatible avec certaines étapes technologiques, et en particulier la recristallisation laser ou SPC du silicium amorphe. Ils sont par ailleurs isolants.

La couche d'oxyde poreuse 2 peut servir de couche d'accrochage pour le silicium. En fonction des applications visées, une couche de planéité ou de nivellement peut être déposée sur la couche de silice poreuse pour offrir une surface la plus plane possible. Cette couche de planéité peut être une couche mince (pour conserver la caractéristique de souplesse) mais dense pour obtenir la planéité et fermer la porosité. Sur le dessin annexé, la référence 3 désigne une couche de silice dense de cent nanomètres à quelques centaines de nanomètres déposée sur la couche de silice poreuse 2. La couche de silice dense 3 peut être déposée par PECVD, mais avantageusement par une technique sol/gel.

Une couche de silicium amorphe 4 est ensuite déposée sur la couche de silice dense 3. La couche 4 peut avoir une épaisseur comprise entre 30 et 150 nm. Son dépôt peut se faire par PECVD à une température comprise entre 150°C et 330°C.

Le silicium amorphe est ensuite cristallisé pour donner du silicium polycristallin, par exemple au moyen d'un faisceau laser UV ou par SPC dans un four adapté à une température typique de 900°C.

Le substrat selon la présente invention peut avantageusement remplacer les substrats à support en verre utilisés pour les écrans de visualisation. Il comprend un support plus mince, meilleur marché et qui est disponible en feuille mince d'épaisseur inférieure à 100 µm.

L'empilement obtenu offre des garanties de bonne tenue mécanique. Le substrat ne casse pas, à la différence des substrats à support en verre. Il peut se conformer à des surfaces non planes. Il reste stable pour les hautes températures de réalisation des transistors TFT inorganiques.

Le support en métal du substrat selon l'invention possède avantageusement une bonne conductivité thermique, ce qui permet l'évacuation des calories produites par l'électronique réalisée sur le substrat. Il peut également servir de plan de masse, moyennant la réalisation d'un contact à travers l'isolant.

L'empilement peut présenter des coefficients de dilatation thermique assez bas, ce qui permet d'éviter d'éventuelles distorsions lors de la réalisation de circuits à partir de la couche de silicium.

Toutes les étapes de préparation du substrat, au moins jusqu'au dépôt du silicium, peuvent se faire, dans l'état des connaissances actuelles, au déroulé par des techniques basses températures, sans avoir besoin de mise au vide des matériaux. Le dépôt est réalisé par voie humide. Tout se fait à pression atmosphérique.

Le substrat est compatible avec l'ensemble des technologies de réalisation des circuits en silicium polycristallin ou amorphe. Cette technologie sert actuellement pour les écrans plats à cristaux liquides. Le substrat supportera notamment les températures des différents procédés qui sont actuellement de 500°C. Il pourra même, selon le substrat employé (c'est le cas pour l'acier inoxydable), supporter des températures supérieures et ainsi rendre possible des traitements plus performants comme la recristallisation SPC et la réalisation d'oxyde thermique.

Le substrat est compatible avec les techniques de cristallisation du silicium par laser.

Ce substrat est aussi compatible avec les technologies de réalisation de circuits à base de composants organiques.

## Revendications

1. Substrat pour application électronique comprenant un support flexible (1) et recouvert successivement d'une couche électriquement isolante (2) et d'une couche de silicium polycristallin ou amorphe (4), **caractérisé en ce que** la couche électriquement isolante (2) est une couche d'oxyde poreuse, ladite couche de silicium (4) présentant une face libre.

2. Substrat selon la revendication 1, **caractérisé en ce qu'**il comprend en outre une couche de nivellement (3) interposée entre la couche d'oxyde poreuse et la couche de silicium polycristallin ou amorphe.

3. Substrat selon la revendication 2, **caractérisé en ce que** la couche de nivellement (3) est une couche d'oxyde dense.

4. Substrat selon la revendication 3, dams lequel la couche de nivellement (3) est en contact direct avec la couche de silicium (4).

5. Substrat selon l'une quelconque des revendications 1 à 4, **caractérisé en ce que** le support (1) est choisi parmi le groupe constitué par une feuille de plastique, une feuille de papier, une feuille métallique souple et un ruban métallique souple.

6. Substrat selon la revendication 5, **caractérisé en ce que** le support (1) est en acier inoxydable.

7. Substrat selon la revendication 5, **caractérisé en ce que** la feuille métallique ou le ruban métalliques sont en un matériau dont le coefficient de dilatation thermique est voisin de celui du silicium.

8. Substrat selon l'une quelconque des revendications 1 à 3, **caractérisé en ce que** le support (1) étant une feuille de plastique ou une feuille de papier, ce support inclut au moins une piste métallique.

9. Substrat selon l'une quelconque des revendications 1 à 8, **caractérisé en ce que** l'oxyde de la couche dioxyde poreuse est choisi parmi les oxydes de métaux ou de métalloïdes TiO₂, Ta₂O₅, Al₂O₃, ZrO₂, HfO₂ et MgO.

10. Substrat selon l'une quelconque des revendications 1 à 8, **caractérisé en ce que** l'oxyde de la couche poreuse est SiO₂.

11. Procédé de fabrication d'un substrat flexible pour application électronique, comprenant les étapes suivantes :
- fourniture d'un support flexible (1),
- dépôt, sur le support (1), d'une couche d'oxyde poreuse (2) par une technique sol-gel,
- dépôt, sur la couche d'oxyde poreuse, d'une couche de silicium amorphe (4) présentant une face libre.

12. Procédé selon la revendication 11, **caractérisé en ce qu'**il comprend en outre une étape de transformation du silicium amorphe en silicium polycristallin.

13. Procédé selon la revendication 11, **caractérisé en ce que** l'étape de fourniture d'un support consiste à fournir un support choisi dans le groupe constitué par une feuille de plastique, une feuille de papier, une feuille métallique souple et un ruban métallique souple.

14. Procédé selon la revendication 13, **caractérisé en ce que** la feuille métallique ou le ruban métallique sont en un matériau dont le coefficient de dilatation thermique est voisin de celui du silicium.

15. Procédé selon la revendication 11, **caractérisé en ce que** le support étant une feuille de plastique ou une feuille de papier, ce support inclut au moins une piste métallique.

16. procédé selon l'une quelconque des revendications 11 à 15, **caractérisé en ce que** le dépôt de la couche d'oxyde poreuse comprend une étape trempage ou d'enduction laminaire.

17. Procédé selon l'une quelconque des revendications 11 à 16, **caractérisé en ce que** la couche de silicium amorphe est déposée par une technique PECVD ou une technique de pulvérisation.

18. procédé selon la revendication 12, **caractérisé en ce que** la transformation du silicium amorphe en silicium polycristallin est réalisée au moyen d'un faisceau laser UV.

19. Procédé selon l'une quelconque des revendications 11 à 18, **caractérisé en ce qu'**il comprend entre l'étape de dépôt de la couche d'oxyde poreuse et l'étape de dépôt de la couche de silicium amorphe, une étape de dépôt d'une couche de nivellement sur la couche d'oxyde poreuse.

20. Procédé selon la revendication 19, **caractérisé en ce que** la couche de nivellement est une couche d'oxyde dense.

21. Procédé selon l'une quelconque des revendications 11 à 20, **caractérisé en ce que** l'oxyde de la couche dioxyde poreuse est choisi parmi SiO₂, TiO₂, Ta₂O₅, Al₂O₃, ZrO₂ et HfO_{2.}

## Claims

1. Substrate for electronic use including a flexible support (1) and covered successively by an electrically insulating layer (2) and a polycrystalline or amorphous silicon layer (4), **characterised in that** the electrically insulating layer (2) is a porous oxide layer, said silicon layer (4) having a free surface.

2. Substrate according to claim 1, **characterised in that** it also includes a levelling layer (3) inserted between the porous oxide layer and the amorphous or polycrystalline silicon layer.

3. Substrate according to claim 2, **characterised in that** the levelling layer (3) is a dense oxide layer.

4. Substrate according to claim 3, wherein the levelling layer (3) is in direct contact with the silicon layer (4).

5. Substrate according to any one of claims 1 to 4, **characterised in that** the support (1) is chosen from the group consisting of a plastic sheet, a paper sheet, a flexible metal sheet and a flexible metal strip.

6. Substrate according to claim 5, **characterised in that** the support (1) is made of stainless steel.

7. Substrate according to claim 5, **characterised in that** the metal sheet or the metal strip is made of a material of which the thermal dilation coefficient is close to that of silicon.

8. Substrate according to any one of claims 1 to 3, **characterised in that** the support (1) is a plastic sheet or a paper sheet, which support includes at least one metal track.

9. Substrate according to any one of claims 1 to 8, **characterised in that** oxide of the porous oxide layer is chosen from the metal or metalloid oxides TiO₂, Ta₂O₅, Al₂O₃, ZrO₂, HfO₂ and MgO.

10. Substrate according to any one of claims 1 to 8, **characterised in that** the oxide of the porous layer is SiO₂.

11. Method for producing a flexible substrate for electronic use, **characterised in that** it includes the following steps:
- providing a flexible support (1),
- depositing, on the support (1), a porous oxide layer (2) by a sol-gel technique,
- depositing, on the porous oxide layer, an amorphous silicon layer (4) having a free surface.

12. Method according to claim 11, **characterised in that** it also includes a step of transforming the amorphous silicon into polycrystalline silicon.

13. Method according to claim 11, **characterised in that** the step of providing a support consists of providing a support chosen from the group consisting of a plastic sheet, a paper sheet, a flexible metal sheet and a flexible metal strip.

14. Method according to claim 13, **characterised in that** the metal sheet or the metal strip is made of a material of which the thermal dilation coefficient is similar to that of silicon.

15. Method according to claim 11, **characterised in that**, the support being a plastic sheet or a paper sheet, said support includes at least one metal track.

16. Method according to any one of claims 11 to 15, **characterised in that** the deposition of the porous oxide layer includes a step of dip coating or roller coating.

17. Method according to any one of claims 11 to 16, **characterised in that** the amorphous silicon layer is deposited by a PECVD technique or a spray technique.

18. Method according to claim 12, **characterised in that** the transformation of the amorphous silicon into polycrystalline silicon is performed by means of a UV laser beam.

19. Method according to any one of claims 11 to 18, **characterised in that** it includes, between the step of deposition of the porous oxide layer and the step of deposition of the amorphous silicon layer, a step of deposition of a levelling layer on the porous oxide layer.

20. Method according to claim 19, **characterised in that** the levelling layer is a dense oxide layer.

21. Method according to any one of claims 11 to 20, **characterised in that** the oxide of the porous oxide layer is chosen from SiO₂, TiO₂, Ta₂O₅, Al₂O₃, ZrO₂ and HfO₂.

## Patentansprüche

1. Substrat zur Anwendung in der Elektronik, enthaltend einen biegsamen Träger (1) und in Abfolge bedeckt mit einer elektrisch isolierenden Schicht (2) und einer Schicht (4) aus polykristallinem oder amorphem Silicium, **dadurch gekennzeichnet, dass** die elektrisch isolierende Schicht (2) eine Schicht aus porösem Oxid ist, wobei die Schicht (4) aus Silicium eine freie Oberfläche präsentiert.

2. Substrat nach Anspruch 1, **dadurch gekennzeichnet, dass** sie weiterhin eine Nivellierungsschicht (3) enthält, die zwischen der Schicht aus porösem Oxid und der Schicht aus polykristallinem oder amorphem Silicium eingefügt ist.

3. Substrat nach Anspruch 2, **dadurch gekennzeichnet, dass** die Nivellierungsschicht (3) eine Schicht aus dichtem Oxid ist.

4. Substrat nach Anspruch 3, **dadurch gekennzeichnet, dass** die Nivellierungsschicht (3) in direktem Kontakt mit der Schicht (4) aus Silicium steht.

5. Substrat nach einem der Ansprüche 1 bis 4, **dadurch gekennzeichnet, dass** der Träger (1) aus der Gruppe, bestehend aus einer Kunststofffolie, einemPapierblatt, einer biegsamen Metallfolie und einem biegsamen Metallband ausgewählt ist.

6. Substrat nach Anspruch 5, **dadurch gekenntzeichnet, dass** der Träger (1) aus rostfreiem Stahl ist.

7. Substrat nach Anspruch 5, **dadurch gekennzeichnet, dass** die Metallfolie oder das Metallband aus einem Material sind, dessen thermischer Ausdehnungskoeffizient in der Nähe des von Silicium ist.

8. Substrat nach einem der Ansprüche 1 bis 3, **dadurch gekennzeichnet, dass** der Träger (1) eine Kunststofffolie oder ein Papierblatt ist, wobei der Träger mindestens einen Metallstreifen enthält.

9. Substrat nach einem der Ansprüche 1 bis 8, **dadurch gekennzeichnet, dass** das Oxid der Schicht aus porösem Oxid aus der Gruppe, bestehend aus den Metall- oder Metalloidoxiden TiO₂, Ta₂O₅, Al₂O₃, ZrO₂, HfO₂ und MgO ausgewählt ist.

10. Substrat nach einem der Ansprüche 1 bis 8, **dadurch gekennzeichnet, dass** das Oxid der porösen Schicht SiO₂ ist.

11. Verfahren zur Herstellung eines biegsamen Substrats für die Anwendung in der Elektronik, umfassend die folgenden Stufen:
- Bereitstellung eines biegsamen Trägers (1),
- Abscheidung einer Schicht (2) aus porösem Oxid auf dem Träger (1) nach einem Sol-Gel-Verfahren;
Abscheidung auf der Schicht aus porösem Oxid einer Schicht (4) aus amorphem Silicium, die eine freie Oberfläche präsentiert.

12. Verfahren nach Anspruch 11, **dadurch gekennzeichnet, dass** es weiterhin eine Stufe der Umwandlung des amorphen Siliciums in polykristallines Silicium umfasst.

13. Verfahren nach Anspruch 11, **dadurch gekennzeichnet, dass** die Stufe Bereitstellung eines Trägers die Bereitstellung eines Trägers, ausgewählt aus der Gruppe, bestehend aus einer Kunststofffolie, einem Papierblatt, einer biegsamen Metallfolie und einem biegsamen Metallband, umfasst.

14. Verfahren nach Anspruch 13, **dadurch gekennzeichnet, dass** die Metallfolie oder das Metallband aus einem Material sind, dessen thermischer Ausdehnungskoeffizient in der Nähe des von Silicium ist.

15. Verfahren nach Anspruch 11, **dadurch gekennzeichnet, dass** der Träger, der eine Kunststofffolie oder ein Papierblatt ist, mindestens ein Metallband enthält.

16. Verfahren nach einem der Ansprüche 11 bis 15, **dadurch gekennzeichnet, dass** die Abscheidung der Schicht aus porösem Oxid eine Stufe der laminaren Befeuchtung oder Überstreichung umfasst.

17. Verfahren nach einem der Ansprüche 11 bis 16, **dadurch gekennzeichnet, dass** die Schicht aus amorphem Silicium nach einem PECVD- Verfahren oder nach einem Zerstäubungsverfahren abgeschieden wird.

18. Verfahren nach Anspruch 12, **dadurch gekennzeichnet, dass** die Umwandlung des amorphen Siliciums in polykristallines Silicium mit Hilfe eines UV-Laserbündels durchgeführt wird.

19. Verfahren nach einem der Ansprüche 11 bis 18, **dadurch gekennzeichnet, dass** es zwischen der Stufe der Abscheidung der Schicht aus porösem Oxid und der Stufe der Abscheidung der Schicht aus amorphem Silicium eine Stufe der Abscheidung einer Nivellierungsschicht auf der Schicht aus porösem Oxid umfasst.

20. Verfahren nach Anspruch 19, **dadurch gekennzeichnet, dass** die Nivellierungsschicht eine Schicht aus dichtem Oxid ist.

21. Verfahren nach einem der Ansprüche 11 bis 20, **dadurch gekenntzeichnet, dass** das Oxid der Schicht aus porösem Oxid aus SiO₂, TiO₂,Ta₂O₅, Al₂O₃, ZrO₂ und HfO₂ ausgewählt ist.
